# EUROPÄISCHE PATENTANMELDUNG

(11) **EP 0 542 149 A2**
(43) Veröffentlichungstag der Anmeldung: **19.05.1993**
(21) Anmeldenummer: 92119045.0
(22) Anmeldetag: 06.11.1992
(51) Int. Cl.: H05K 3/34

(54) **Verfahren zur Herstellung von Lotflächen auf einer Leiterplatte und Lotpastenfolie zur Durchführung des Verfahrens**

(30) Priorität: 11.11.1991 DE 4137045
(71) Anmelder: SIEMENS AKTIENGESELLSCHAFT, D-80333 München (DE); DU PONT DE NEMOURS INTERNATIONAL S.A., CH-1218 Le Grand-Saconnex (Genève) (CH)
(72) Erfinder: Maiwald, Werner, Dipl.-Phys., W-8202 Bad Aibling (DE); Weinhold, Michael, CH-1228 Plan-les-Quates (CH)
(74) Vertreter: Fuchs, Franz-Josef, Dr.-Ing.

(57) **Zusammenfassung**

Zur Herstellung von Lotflächen (8) auf elektrisch leitfähigen Bereichen (2) einer Leiterplatte (1) ist eine Lotpastenfolie (4) vorgesehen. Die Folie wird ganzflächig auf der Leiterplatte aufgetragen und danach strukturiert. Nach dem Aufbringen von Lotpaste (6) wird die strukturierte Lotpastenfolie (5) entfernt. Vorteilhaft wird die Lotpastenfolie gleich wie eine darunterliegende Lötstoppfolie (3) strukturiert. Die Lotpaste (6) wird zweckmäßigerweise vor Entfernen der strukturierten Lotpastenfolie (5) zu Lotdepots (7) umgeschmolzen.

## Beschreibung

Die Erfindung betrifft ein Verfahren zur Herstellung von Lotflächen auf einer Leiterplatte, bei dem mittels einer Maske auf elektrisch leitfähige Bereiche der Leiterplatte Lotpaste aufgetragen und nachfolgend geschmolzen wird.

Bei der Fertigung elektronischer Baugruppen hat die Oberflächenmontierung von Bauelementen gegenüber der Kontaktlochmontierung von Bauelementen eine wesentliche Bedeutung erlangt. Die höhere Packungsdichte oberflächenmontierter Bauelemente (SMC, Surface Mount Components) auf gedruckten Leiterplatten (PCB, Printed Circuit Bords) erfordert reduzierte Abstände zwischen den Bauelementen sowie kleinere Abmessungen der Lötpunkte und deshalb eine höhere Anzahl von Lötpunkten auf jeder Leiterplatte. Daraus und durch die schwierigere Leiterplattenkontrolle ergibt sich ein Zwang zu einem möglichst perfekten Verlöten der Bauelemente. Neben der Qualitätssicherung bei der Fertigung besteht als zusätzliche Rahmenbedingung die Forderung, die Herstellungskosten so gering wie möglich zu halten.

In der Oberflächenmontagetechnik (SMT, Surface Mounted Technology) bieten direkt verarbeitbare Leiterplatten große Vorteile. Dabei werden vorbelotete reflow-lötfähige SMD-Leiterplatten unmittelbar mit SMD-Bauelement bestückt. Die Kontakt- oder Leiteranschlüsse der Bauelemente werden in Bezug auf entsprechende Kontaktanschlüsse eines Substrats bzw. der Leiterplatte ausgerichtet und nach dem Reflow-Lötverfahren verlötet. Das Lot muß dabei eine ausreichende Qualität besitzen, um die Kontaktanschlüsse des Bauelements zu benetzen und alle Zwischenräume zwischen den Kontaktanschlüssen des Bauelements und der Leiterplatte zu schließen.

Die gegenwärtig mit Abstand am weitesten verbreitete Technik bei der Verarbeitung hochpoliger integrierter Schaltkreise ist die Lotpastentechnik.

Aus der US-PS 4,752,027 ist ein Verfahren zum Beloten von Leiterplatten mit Bauelementen bekannt, bei dem auf Lötpads, beispielsweise einer auf der Leiterplatte aufgebrachten leitfähigen Kupferkaschierung, durch Siebdruck oder Matrizendruck Lotpaste aufgebracht wird, die anschließend im Ofen getrocknet und reflow-behandelt wird. Das damit erhaltene Muster auf der Leiterplatte mit konvexen Lötpunkten wird sorgfältig gereinigt, bevor die Leiterplatte mit Rollen bearbeitet wird, die die Oberflächen der Lötpunkte flachdrücken und nivelieren. Nach dem Aufbringen von Flußmittel und der Bestückung mit Bauelementen werden die Lötpunkte und die Anschlüsse des Bauelements miteinander verlötet.

Aus Patent Abstracts of Japan, Vol. 14, No. 336 (E-953) |4279|, 19. Juli 1990 ist beispielsweise bekannt, zwischen den Lötpunkten (Lötpads) eine Lötstoppmaske aufzubringen. Nach dem Bestücken der Leiterplatte mit Bauelementen werden die gebildeten Lotdepots im Reflow-Ofen langsam bis über den Schmelzpunkt der jeweiligen Lotlegierung erwärmt und so durch Aufschmelzen der Lotpaste die Lotverbindung hergestellt. Der Auftrag der Lotpaste erfolgt auch bei diesem Verfahren mit Hilfe eines Druckverfahrens, z.B. Siebdruck oder Metallschablonendruck, oder mit einem Dosierverfahren für die Lotpaste.

Aus der Veröffentlichung Ch. Koenen: Sieb oder Metallschablone?, Beilage einer Firmenschrift der Koenen GmbH, Ottobrunn, Februar 1990 sind Vor- und Nachteile des jeweiligen Druckverfahrens bekannt. Beiden Verfahren gemeinsam ist, daß die Fixkosten für die Herstellung des Siebes oder der Metallschablone relativ hoch sind. Insbesondere Metallschablonen eignen sich deshalb nur für nicht zu kleine Losgrößen. Sowohl eine Sieb- als auch eine Metallschablone müssen in einen hochwertigen Rahmen eingespannt werden, der in Bezug zur zu bedruckenden Leiterplatte justiert werden muß. Besonders bei Leiterplatten mit vielen möglicherweise filigranen Lötpunkten treten dabei Verzugs- und Justierfehler auf. Typischerweise können die Fehler nur ausgemittelt werden.

Der Erfindung liegt die Aufgabe zugrunde, die bekannten Verfahren zur Herstellung von Lotflächen auf einer Leiterplatte zu verbessern und insbesondere eine Möglichkeit anzugeben, mit der sich die Lotpastentechnik bei kleinen Losgrößen wirtschaftlich einsetzen läßt. Weiterhin soll eine Möglichkeit zur Durchführung des Verfahrens angegeben werden.

Diese Aufgabe wird erfindungsgemäß mit den Merkmalen der Patentansprüche 1 und 9 gelöst.

Die Erfindung hat den Vorteil, daß die Herstellung von Lotflächen auf einer Leiterplatte ohne eines der bekannten Druckverfahren möglich ist. Damit entfallen vergleichsweise hohe Kosten für die Schablonenherstellung sowie Probleme, die durch Verzug des Rahmens bzw. des Siebes oder der Metallschablone auftreten können. Auch Justierfehler können drastisch reduziert werden. Durch die Verwendung einer mit Hilfe der Fototechnik strukturierbaren Lotpastenfolie ergibt sich, bezogen auf die Lötpunkte, eine ausgezeichnete Präzision beim Auftrag der Lotpaste. Das Verfahren eignet sich bis zu kleinsten Losgrößen, insbesondere die Losgröße 1. Die Erfindung hat weiterhin den Vorteil, daß nur sehr geringe Anforderungen an die Haftung der Lotpastenfolie auf der Unterlage gestellt werden müssen, weil die Lotpastenfolie nach dem Aufbringen der Lotpaste und ggf. deren Aufschmelzen wieder entfernt wird. Als Lotpastenfolie eignen sich deshalb fotosensitive Kunststofffolien, beispielsweise eine entsprechende Polyesterfolie, oder ein Resistlack bzw. Resistfilm.

Ausgestaltungen der Erfindung sind in Unteransprüchen gekennzeichnet.

Die Erfindung wird nachfolgend anhand eines Ausführungsbeispiels und den Figuren der Zeichnung näher erläutert. Es zeigen:

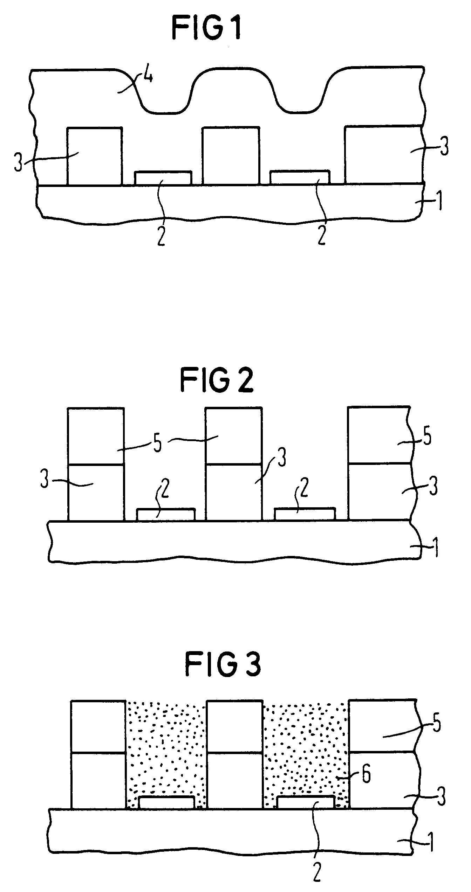

Figur 1 bis Figur 5 schematische Schnittdarstellungen einer Leiterplatte nach unterschiedlichen Schritten bei der Herstellung von Lotflächen.

Gemäß Figur 1 ist auf einer Leiterplatte 1 aus einem Basismaterial an Stellen für SMD-Lötbereiche eine leitfähige Kupferkaschierung 2 (Lötpads) in an sich bekannter Weise aufgebracht. Die Lötpads 2 können durch eine Lötstoppfolie 3 begrenzt werden. Üblicherweise besteht die Lötstoppfolie aus Kunststoff. Die Lötstoppfolie kann beispielsweise fototechnisch strukturiert sein und ist resistent gegen übliche Lösungs-, Wasch- und Reinigungsmittel. Darüber hinaus ist die Lötstoppfolie temperaturbeständig mit einem Sicherheitsabstand zum Schmelzpunkt des verwendeten Lots. Eine gute Haftung auf der Leiterplatte 1 muß gewährleistet sein. Es ist jedoch zu erwähnen, daß eine Lötstoppfolie nicht zwingend vorgesehen sein muß. Die Figuren stellen aber ein bevorzugtes Ausführungsbeispiel dar.

Auf der Leiterplatte 1 mit den elektrisch leitfähigen Bereichen 2 und der Lötstoppfolie 3 gemäß Ausführungsbeispiel wird eine Lotpastenfolie 4 aufgetragen, beispielsweise durch Auflaminieren. Die Lotpastenfolie 4 ist fotosensitiv, d.h., daß sie sich nach einer fototechnischen Belichtung an den belichteten Stellen leicht entfernen läßt. Beispielsweise kann ein fotosensitiver Lack oder ein fotosensitiver Film eingesetzt werden. Es ist aber auch möglich, eine Kunststoffolie vorzusehen, beispielsweise aus Polyester. Lacke, Folien und Filme lassen sich mit den in der Halbleitertechnik üblichen Materialien fototechnisch strukturieren. Für das Auswaschen einer Kunststofffolie eignet sich beispielsweise eine wässrige alkalische Lösung. An die Haftung der Lotpastenfolie auf dem Untergrund werden keine besonders hohen Anforderungen gestellt.

Nach einer Strukturierung der Lotpastenfolie, beispielsweise mit Hilfe einer Fototechnik, ergibt sich eine strukturierte Lotpastenfolie 5 gemäß Figur 2, die als Maske dient. Zweckmäßigerweise ist die Strukturierung gleich wie bei der Lötstoppmaske, so daß sich die vertikalen Seiten der Lotpastenfolie und der Lötstoppfolie decken. Die Dicke der Lotpastenfolie beträgt zwischen 50 und 200 µm. Es ist vorteilhaft, dafür zu sorgen, daß die strukturierte Lotpastenfolie 5 auf jeder Leiterplatte eine gleichmäßige Dicke aufweist. Es ist zweckmäßig, das Material für die Lotpastenfolie so zu wählen, daß es sich selektiv bezüglich der Lötstoppfolie 3 entfernen läßt. Darüber hinaus muß die Lotpastenfolie temperaturbeständig mit einem vorgegebenen Sicherheitsbereich in Bezug auf den Schmelzpunkt des einzusetzenden Lots sein. Beträgt der Schmelzpunkt etwa 183°, dann sollte die Lotpastenfolie bis etwa 220° temperaturbeständig sein, jedoch sind auch niedrigere Temperaturen noch tragbar. Besser sind höhere Temperaturfestigkeiten.

Gemäß Figur 3 ist in die Vertiefungen zwischen der Lötstoppfolie und der Lotpastenfolie Lotpaste 6 eingefüllt, was beispielsweise mit Hilfe eines Rakels oder eines Spachtels geschehen kann. Übliche Durchmesser von Lotpastenkugeln betragen 20 bis 80 µm. Vorzugsweise wird die Lotpaste 6 in einem anschließenden Verfahrensschritt umgeschmolzen. Dies kann beispielsweise durch einen Reflow-Prozeß geschehen. Das Volumen der Lotpaste 6 wird dabei etwa auf die Hälfte reduziert.

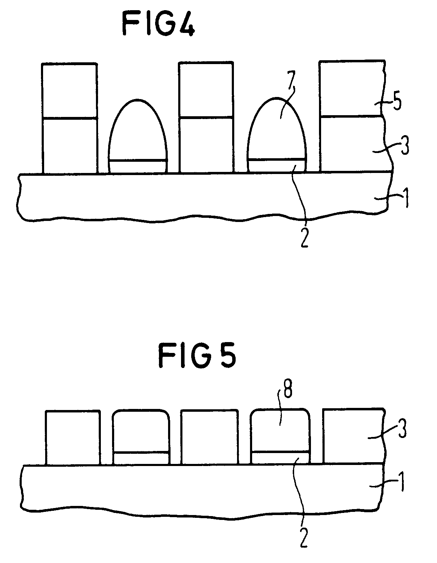

Figur 4 zeigt die aus der umgeschmolzenen Lotpaste gebildeten massiven Lotdepots 7. Die Strukturierung der Lötstoppfolie und der Lotpastenfolie in Verbindung mit der Dicke der einzelnen Folien kann so gewählt werden, daß die massiven Lotdepots 7 etwa das gleiche Volumen besitzen wie die Vertiefung in der Lötstoppfolie bezüglich des jeweils elektrisch leitfähigen Bereichs 2. Die Lotdepots 7 sind aber nach dem Umschmelzen bucklig und deshalb über die Lötstoppfolie 3 erhaben.

In einem anschließenden Verfahrensschritt wird die Lotpastenfolie 5 entfernt. Dies ist mit alkalisch wässrigen Strippern möglich. Zusätzlich wird das Flußmittel beseitigt.

Figur 5 zeigt die Anordnung, nachdem die Lotpastenfolie 5 entfernt wurde und in einem anschließenden Wärmeprozeß die buckligen Lotdepots 7 zu Lotdepots 8 flachgepreßt und unter Druck abgekühlt wurden, so daß sie bündig mit der Oberfläche der Lötstoppfolie 3 abschließen. Es entsteht eine Lotreserve für das Verloten der noch zu bestückenden Bauelemente, weil das Lot beim Erwärmen wieder eine bucklige Form einnehmen will.

Dieses Verfahren der Wärmebehandlung ist in der nicht vorveröffentlichten europäischen Patentanmeldung EP 90123005.2 beschrieben.

Die Erfindung ermöglicht die wirtschaftliche Realisierung einer Losgröße 1 für die gesamte Baugruppenfertigung, da nahezu keine Werkzeug- und Rüstkosten verglichen mit dem bekannten Stand der Technik auftreten. Zumindest ergibt sich bei kleinen und mittleren Stückzahlen eine ganz wesentliche Kostenersparnis. Darüber hinaus ermöglicht die Erfindung eine bestmögliche Genauigkeit der Maskenstruktur und der Maskenjustage, da für die Strukturierung der Folien ein optisches Verfahren benutzt werden kann, indem beispielsweise der Originalfilm für die Leiterplatten ebenfalls für die Lotflächenherstellung verwendet wird.

Neben der vorstehend beschriebenen Anordnung ist auch der Einsatz einer zweilagigen Folie z.B. als Zweilagenpolymerfilm vorgesehen, bei der eine Lage als Lötstoppfolie und die andere Lage als Lotpastenfolie dient. Eine derartige zweilagige Folie kann in einem Arbeitsgang aufgetragen und zur Herstellung einer Maske für die Lotpaste strukturiert werden. Nach dem Umschmelzen der Lotpaste wird die temporäre Folie, d.h. die Lotpastenfolie entfernt, so daß nur die Permanentfolie, d.h. die Lötstoppfolie auf der Leiterplatte bleibt.

## Patentansprüche

1. Verfahren zur Herstellung von Lotflächen auf einer Leiterplatte, bei dem mittels einer Maske auf elektrisch leitfähige Bereiche der Leiterplatte Lotpaste aufgetragen und nachfolgend geschmolzen wird, **gekennzeichnet** durch folgende Schritte:
- auf die Leiterplatte (1) mit den elektrisch leitfähigen Bereichen (2) wird ganzflächig eine fotosensitive Lotpastenfolie (4) aufgetragen,
- die Lotpastenfolie (4) wird mit einer Fototechnik belichtet und anschließend strukturiert (5),
- die Lotpaste (6) wird aufgetragen,
- die strukturierte Lotpastenfolie (5) wird entfernt.

2. Verfahren nach Anspruch 1, **dadurch gekennzeichnet,** daß vor dem Auftragen der Lotpastenfolie (4) eine strukturierte Lötstoppfolie (3) erzeugt wird.

3. Verfahren nach einem der Ansprüche 1 bis 2, **dadurch gekennzeichnet,** daß die Lotpastenfolie (4) auflamminiert wird.

4. Verfahren nach Anspruch 1, **dadurch gekennzeichnet,** daß eine Lötstoppfolie (3) mit der Lotpastenfolie (4) als zweilagige Folie aufgetragen und strukturiert wird.

5. Verfahren nach einem der Ansprüche 2 bis 4, **dadurch gekennzeichnet,** daß die Lötstoppfolie (3) und die darüberliegende Lotpastenfolie (4) gleich strukturiert werden.

6. Verfahren nach einem der Ansprüche 1 bis 5, **dadurch gekennzeichnet,** daß die Lotpaste (6) nach dem Auftragen zu massiven Lotdepots (7) umgeschmolzen wird.

7. Verfahren nach einem der Ansprüche 2 bis 6, **dadurch gekennzeichnet,** daß die Lotpastenfolie (4) selektiv bezüglich der Lötstoppfolie (3) entfernbar ist.

8. Verfahren nach einem der Ansprüche 1 bis 7, **dadurch gekennzeichnet,** daß die Lotpastenfolie (4) in einer Dicke von 50 bis 200 µm aufgetragen wird.

9. Lotpastenfolie zur Durchführung des Verfahrens nach einem der Ansprüche 1 bis 8, **gekennzeichnet** durch die Ausbildung als fotosensitive Folie (4), die mit einem vorgebbaren Abstand zum Schmelzpunkt des Lots temperaturbeständig sowie strukturierbar ist.

10. Lotpastenfolie nach Anspruch 9, **dadurch gekennzeichnet,** daß ein Lack oder ein Film oder eine Kunststoffolie vorgesehen ist.
